# EUROPEAN PATENT APPLICATION

(11) **EP 1 469 629 A1**
(43) Date of publication of application: **20.10.2004**
(21) Application number: 03290930.1
(22) Date of filing: 14.04.2003
(51) Int. Cl.: H04L 7/00

(54) **Method and apparatus for generating a phase shifted output clock signal**

(71) Applicant: Infineon Technologies AG, 81669 München (DE)
(72) Inventor: Koren, Ivo, Dr., 81737 München (DE); Le Tual, Stéphane, 38113 Veurey-Voroize (FR); Kirmser, Stéphane, 80687 München (DE)
(74) Representative: Banzer, Hans-Jörg, Dipl.-Ing.

(57) **Abstract**

A method and an apparatus for generating an output clock signal (h, i, k, 1) with variable phase is presented. The output clock signal (h, i, k, 1) is generated by deriving at least two further clock signals (d, e, f, g) having a predetermined phase shift from a master clock signal and then generating the output clock signal (h, i, k, 1) by interpolating between at least two further clock signals (d, e, f, g). This method or apparatus can be especially used for clock synchronization in communication systems with counter-directional clocking.

## Description

The present invention relates to a method and an apparatus for generating phase shifted clock signals from a master clock signal. Especially, it relates to a method and an apparatus which can be used for data interface synchronization using counter-directional clocking.

There are principally two basic methods to synchronize a data interface between two subsystems using synchronization clocks: co-directional clocking and counter-directional clocking.

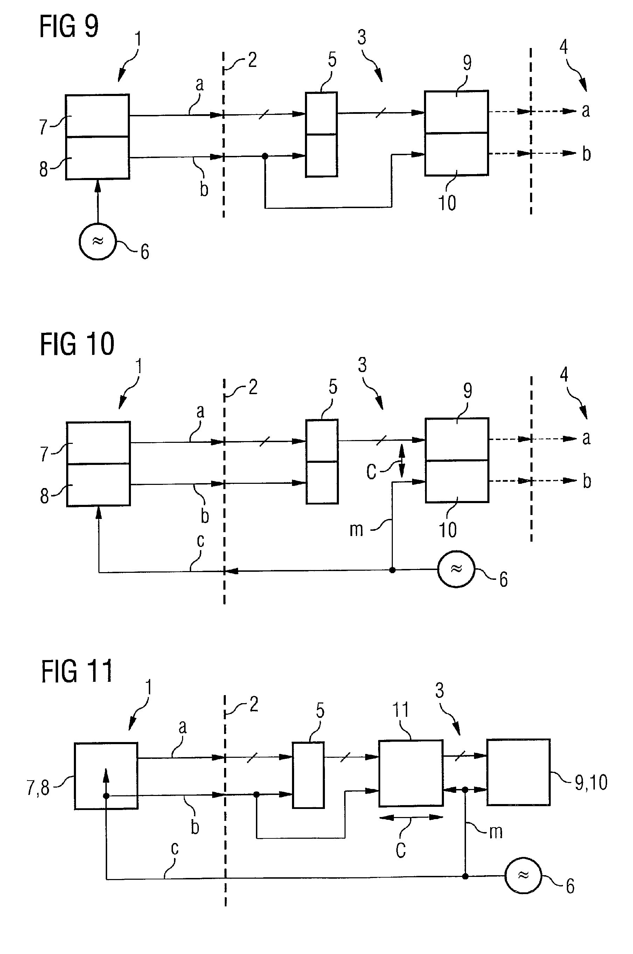

In Figure 9, a communication system using co-directional clocking is shown. A transmitting subsystem or transmitter 1 transmits data over a data interface 2 to a receiving subsystem or receiver 3. The data may be further forwarded to a following subsystem 4. The transmitting subsystem comprises a data transmitter 7 which outputs a data signal a having a certain number of parallel channels or bitwidth and a clock generation device 8 which outputs a data clock signal b derived from a master clock signal from a master clock 6. The data signal a and the data clock signal b are received by the receiving subsystem 3. Data re-timing means 5 may be provided which help to increase the tolerance of the receiving subsystem to data signal degradation due to non-ideal transmission. A data receiver 9 receives the data using the data clock signal b, and both the data signal a and the data clock signal b may be forwarded to the following subsystem 4. To that end, a receiver clock generator 10 may be used. In this case of co-directional clocking, the master clock 6 is on the side of the transmitting subsystem 1, so data and the synchronization clock are propagated in the same direction through the system. The advantage of co-directional clocking is that it is relatively simple. On the other hand, it leads to relatively large jitter and wander in the receiver clock generator 10 of the receiving subsystem 3 with respect to the master clock 6.

Figure 10 shows a communication system using counter-directional clocking. The system is basically the same as the system depicted in Figure 9 with the exception that now the master clock 6 is incorporated in the receiving subsystem 3. The master clock signal m is directly used in the receiving subsystem and additionally is sent as a transmission clock signal c to the transmitting subsystem 1. There, the transmission clock signal c is used to generate the data clock signal b. Counter-directional clocking allows for precise clock generation in the receiving subsystem, which is especially important when the receiving subsystem drives external interfaces, like line or bus drivers or optical transmitters. As the master clock signal first traverses the data interface 2 to provide the transmission clock source c and then returns across the data interface 2 as the data clock signal b, a phase shift indicated by an arrow C with respect to the master clock signal m may be generated by variations of the phase along the clock signal path. Therefore, the data signal a which is basically in phase with the data clock signal b needs to be synchronized with the master clock signal m.

In Figure 9 and Figure 10, the data clock signal is optional. The data signal a may also be used directly for determining the data clock.

In the art, there are basically three usual methods for data synchronization with counter-directional clocking.

In Figure 11, data synchronization using a FIFO-memory 11 ("First In First Out") is shown. The remaining reference numerals designate the same elements as in Figures 9 and 10. Here, a variable phase difference between the incoming data signal a and the master clock signal or internal receiver clock signal m is accommodated using the FIFO-memory 11 of fixed depth. The advantage of the FIFO-synchronization is the simple design. Disadvantages are a large circuit complexity and, consequently, a large area and power consumption for a large depth of the FIFO-memory and a large number of data channels.

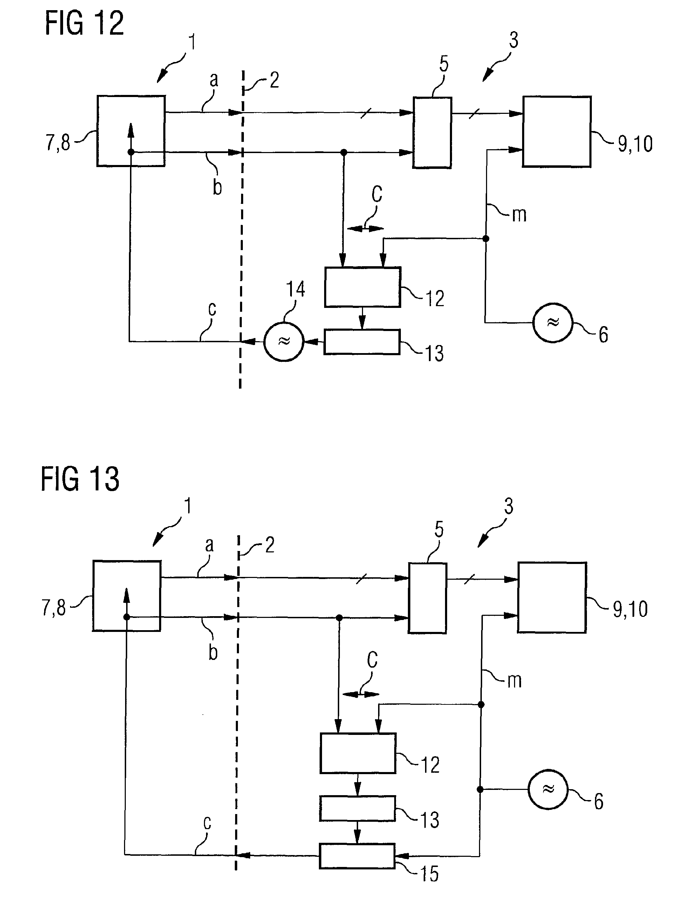

In Figure 12, data synchronization using a phase locked loop (PLL) is shown. The phase difference between the data clock signal b and the master clock signal m is held constant at a low value by a feedback loop, including a phase detector 12, a loop filter 13 and a voltage controlled oscillator (VCO) 14 which generate the transmission clock signal c. Thus, by adjusting this transmission clock signal c, the clock of the data signal a is synchronized with the master clock signal m. The advantage of the PLL synchronization is the correction of unlimited round trip delay variations. The disadvantages are the high design effort using analog circuitry like the VCO and a potential instability of the feedback loop.

Figure 13 shows a similar concept for data synchronization using a delay locked loop (DLL). The DLL circuit comprises a phase detector 12, a loop filter 13 and an analog variable delay element 15 which generates the transmission clock signal c from the master clock signal m by delaying it, thus shifting its phase by a variable phase shift. The advantage of the DLL synchronization is the simple design (no voltage controlled oscillator, no stability problems). The disadvantage is the limited range of round trip delay compensation. Also, if a compensation of more than one clock period is required, which is usually the case when the transmitting subsystem is a CMOS logic device, it is difficult to initialize the DLL correctly due to multiple stable states which the loop can lock in.

Therefore, a data synchronization circuit is needed which has a simple design, an unlimited compensation range and which may operate with virtually any transmission clock generation circuitry. As a central element, a method and an apparatus for generating a phase shifted output clock signal with respect to a master clock signal is needed. It is therefore an object of the present invention to provide such a method and such an apparatus for generating a phase shifted output clock signal with respect to a master clock signal which has a simple design, can generate an unlimited range of phase shift and does not produce any spikes when changing the phase of the output clock signal, and is thus operable with virtually any transmission clock generation circuitry.

This object is achieved by a method according to claim 1 and an apparatus according to claim 13, respectively. The dependent claim define preferred or advantageous embodiments of the method and the apparatus, respectively. In particular, embodiments for using the method or the apparatus for data synchronization are defined.

According to the invention, for generating an output clock signal, at least two further clock signals having a predetermined phase shift are derived from a master clock signal. Then, the output clock signal is generated by interpolating between the at least two further clock signals. Thus, the output clock signal with a determined phase difference with respect to the master clock signal is generated.

Advantageously, first at least two intermediate clock signals having a predetermined phase shift are derived from the master clock signal and then each of the at least two further clock signals is generated by multiplying one of the at least two intermediate clock signals by a respective multiplier. Thus, by changing the multiplier, a change in the phase of the output clock signal can be easily achieved.

The interpolating between the at least two clock signals may be achieved by adding the amplitude of the at least two further clock signals. To do this, it is desirable that the at least two further clock signals have a suitable waveform, for example a rectangular waveform filtered by a low pass filter.

An apparatus using such a method may be used for data synchronization, in particular for data synchronization using couter-directional clocking. For example, the multipliers may be changed in a way so that the phase of the output clock signal changes according to a desired phase change determined by a phase detector. For determining the multipliers, an analog-digital-converter (A/D-converter) in connection with a logic circuitry or logic block for determining the multipliers from a digitized phase difference signal may be used. The logic circuitry may be realized as a state machine.

With the method or apparatus according to the invention, a synchronization circuit having simple circuitry and simple design with an unlimited compensation range and interoperability with virtually any transmission clock generation circuitry may be realized, where no spikes occur in the output clock signal.

In the following, preferred embodiments of the present invention will be described in detail with reference to the accompanying drawings, wherein:
Figure 1 is a schematic drawing for explaining the method of generating an output clock signal according to a preferred embodiment of the invention,
Figure 2 shows exemplary charts of signals shown in Figure 1 in the time domain,
Figure 3 shows a data synchronization circuit using a method according to the present invention,
Figure 4 schematically shows the working principle of an analog-digital-converter of Figure 3,
Figure 5 shows the compensation of a continuous phase wander of a data signal,
Figure 6 shows a state diagram for a state machine which may be used in a logic block in Figure 3,
Figure 7 shows a state diagram for another state machine which may be used in the logic block,
Figure 8 shows a possible implementation of the synchronization circuit shown in Figure 3,
Figure 9 schematically shows the principle of co-directional clocking,
Figure 10 schematically shows the principle of counter-directional clocking,
Figure 11 shows an example for a prior art data synchronization using a FIFO,
Figure 12 shows an example for a prior art data synchronization using a phase locked loop, and
Figure 13 shows an example for a prior art data synchronization using a delay locked loop.

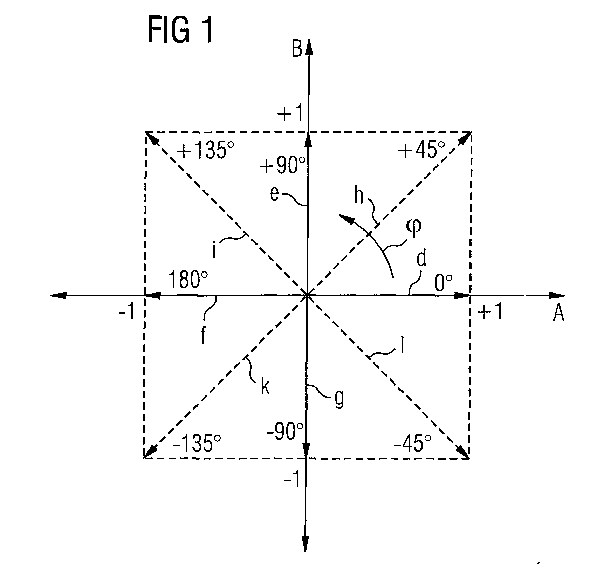

In Figure 1, the principle of the generation of an output clock signal according to a preferred embodiment of the present invention is shown in the form of a polar diagram. The direction of the different arrows indicates the phase of respective signals.

According to this example, two intermediate signals d and e are generated by phase shifting a master clock signal by 0° and by a phase shift ϕ, in this case 90°, respectively. Of course, for the intermediate signal d, the master clock signal can be directly used as well. These two intermediate clock signals are then multiplied by multipliers (multiplication or weighing factors) A and B, respectively, which are depicted at the two axes of Figure 1. A and B can be either +1 or -1 in this example. Multiplying intermediate signal d by -1 results in signal f, multiplying intermediate signal e by -1 results in signal g. The signals d, e, f and g constitute further clock signals. An output clock signal is then generated by combining, for example by adding the amplitudes, of at least two of the further clock signals. By interpolating between signal d and signal e, an output clock signal h is generated. By interpolating between further clock signal e and further clock signal f, an output clock signal i is generated. In the same way, output clock signals k and l can be generated.

Thus, four different output clock signals h, i, k and l can be generated by multiplying the intermediate signals d and e with either +1 or -1 and interpolating between the results.

Of course, in principle, the interpolation can also be carried out between more than two further clock signals. Furthermore, the angle ϕ can also be different from 90°, or more than one intermediate clock signal can be generated.

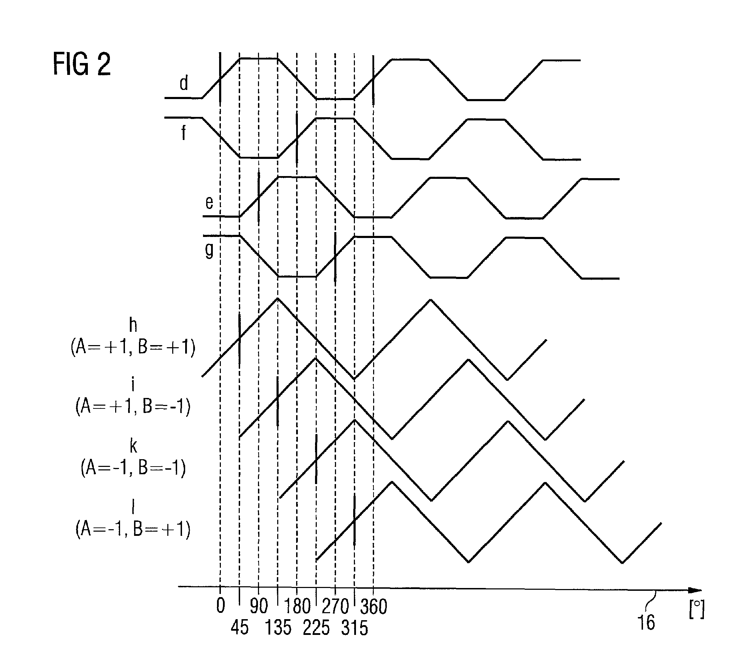

Figure 2 shows a chart of the different signals of Figure 1 in the time domain. The wave form of the further clock signals d, f, e and g shown can be achieved by using a rectangular master clock signal filtered by a low pass filter. It is also possible to apply the low pass filter before interpolating between two further clock signals. The low pass filter preferably has a time constant of at least one fourth of the period of the signals. For example, for a 2.5 GHz clock signal, the time constant should be at least 100 ps.

In the lower half of Figure 2, the possible output clock signals h, i, k and l are shown together with the respective values of the multipliers A and B. It can be easily seen that just by changing the multipliers, four different output clock signals with a phase difference of 90° between one another can be generated.

By using for example 0 as a further possible value of the multipliers, the signals d, f, e and g can be also used as output clock signals. In this way, eight different output clock signals with a phase difference of 45° between one another can be generated just by changing the multipliers.

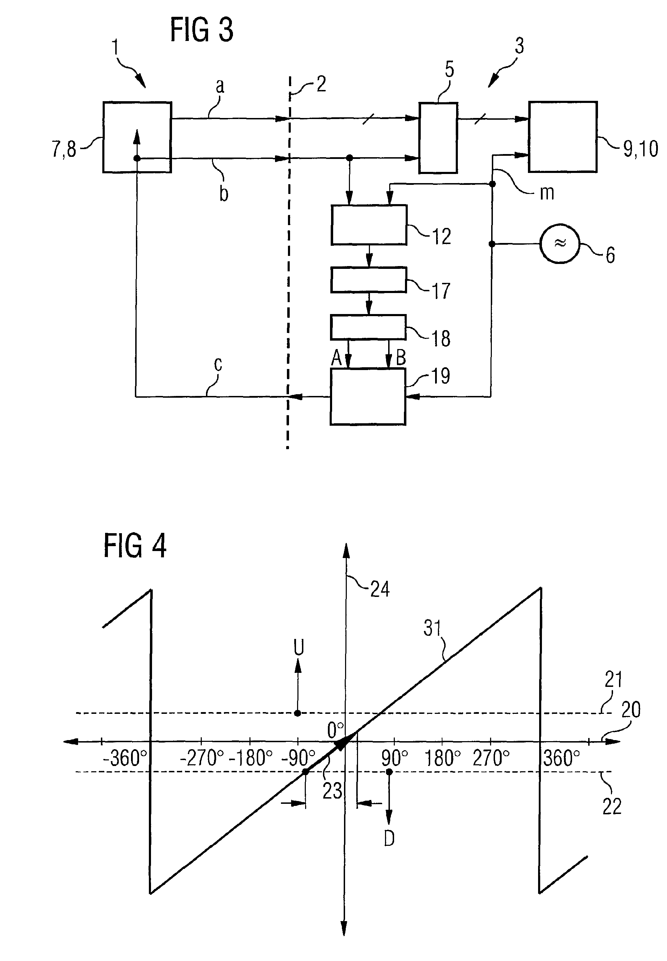

An apparatus, a so-called cyclic phase stepper, employing this method can be used for data synchronization in a communication system using counter-directional clocking, as shown in Figure 3. The reference numerals already used in the introduction with respect to Figures 9 to 13 refer to the same elements in the case of Figure 3.

In order to compensate for a phase difference between a data clock signal b and a master clock signal m generated by a master clock 6, a synchronization device comprising a phase detector 12, an analog-digital-converter (ADC) 17, a logic block 18 and a cyclic phase stepper 19 employing the method described above is used. Thus, the phase of an output clock signal c, which is the output signal of the cyclic phase stepper 19 and serves as a transmission clock signal, can be varied. In consequence, the phase of the data clock signal b (and of the data signal a) changes so that synchronization can be obtained.

As the phase detector 12, any conventional phase detector like the one in the phase locked loop or delay locked loop synchronization circuits presented in the introduction can be used. The ADC 17 may be a 1.5 bit ADC which generates an UP signal to indicate that the phase of the output clock signal should be changed in the positive direction, a DOWN signal to indicate that it should be changed in the negative direction or no signal if no adjustment is needed. This is schematically shown in Figure 4. Curve 31 represents the magnitude of the phase difference between the data clock signal b and the master clock signal m, the magnitude being indicated along the axis 24. When the phase difference drops, coming from 0, below a certain lower limit 22, an UP signal is generated, as indicated by point U), to indicate that the phase of the output clock signal should be shifted in the positive direction, and if the phase difference becomes greater than a certain upper limit 21, a corresponding DOWN signal is generated at point D so as to shift the phase of the output clock signal in the negative direction.

This UP or DOWN signal is then transmitted to the logic block 18, which changes the multipliers A and B described above so that the output clock signal is shifted by one phase step in the direction indicated by the UP or the DOWN signal. The phase of the output clock signal is indicated on axis 20. In Figure 4, when the phase difference drops below the lower limit 22, the multipliers A and B are changed so that the output clock signal changes its phase by for example +90° as indicated by arrow 23. This is for example for the case where the multipliers may be either +1 or -1. In case of more values for the multipliers or more further clock signals which can be combined, a finer step than 90° is possible, and the limits 21 and 22 may be adjusted accordingly.

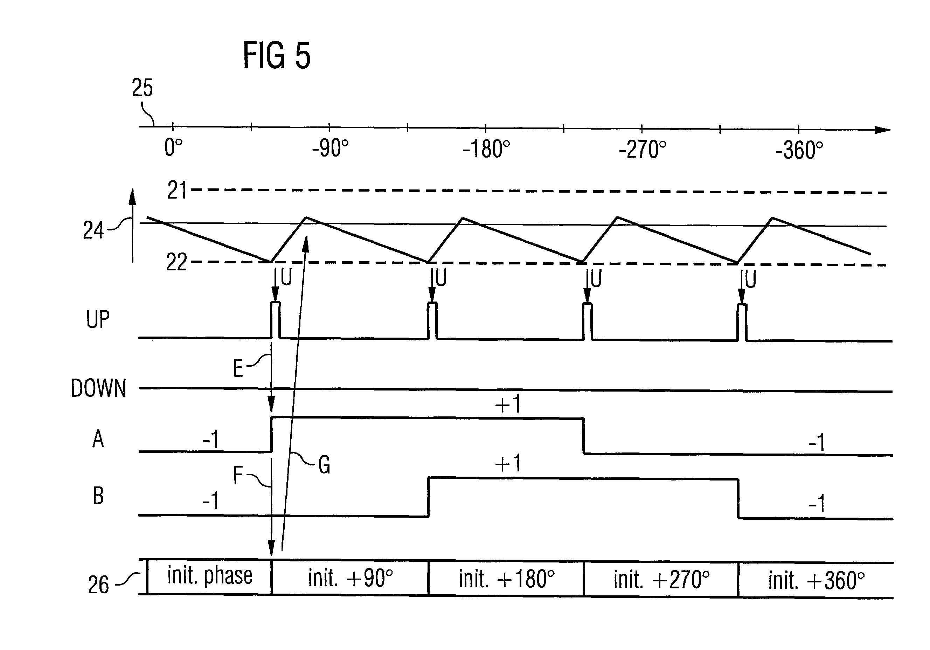

In Figure 5, continuous phase compensation for a continuous wander of the round trip delay is shown. The example is again for a 1.5 bit ADC and 90° steps of the cyclic phase stepper, as shown in Figure 1. Of course, a corresponding method can be used with a cyclic phase stepper with 45° steps and for multipliers with values -1, 0 and +1.

On axis 25 of Figure 5, the phase wander in a negative direction due to round trip delay is shown. On axis 24, the phase difference as determined by the phase detector 12 between the phase of the data clock signal b and the master clock signal m is shown. Every time the phase difference reaches the lower limit 22, an UP signal is generated indicated by arrows U. The UP and DOWN signals are shown by corresponding lines of Figure 5. As can be seen the upper limit 21 is never reached, and no DOWN signal is generated.

The UP and DOWN signals are processed by the logic block 18 to determine the multiplier A for the intermediate clock signal d of Figure 1 and the multiplier B for the intermediate clock signal e of Figure 1, as indicated by arrow E. The evolution of the multipliers A and B with increasing negative phase wander is shown by respective lines of Figure 5. The changing of the multipliers causes a corresponding change in the phase of the signal generated by the cyclic phase stepper 19, as indicated with arrow F. From the initial phase, it changes to the initial phase plus 90°, then to the initial phase plus 180°, and so on. With some delay, caused by the round trip delay from the output clock signal c to the data clock signal d, the phase difference 24 is brought back towards the middle of the window defined by the lower limit 22 and the upper limit 21, as indicated by arrow G.

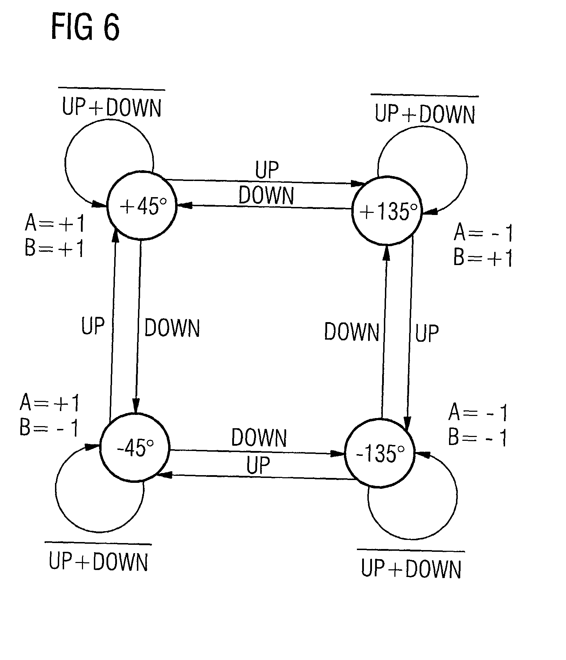

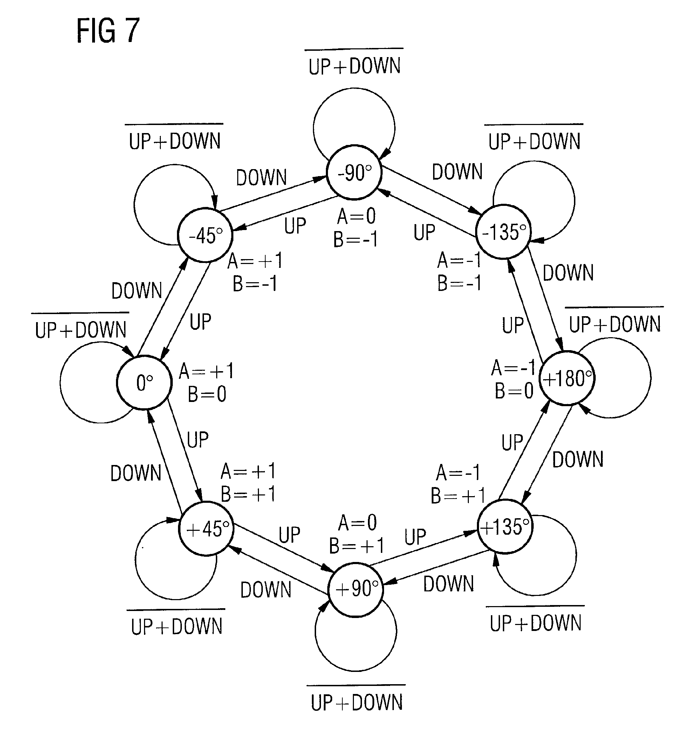

In Figures 6 and 7, examples for possible implementations of the logic block 18 as a state machine are shown.

Figure 6 is an example for a state machine where the multipliers A and B can only assume the values +1 and -1. Thus, the state machine shown in Figure 6 corresponds to the cyclic phase stepper whose principle is shown in Figure 1. The four possible states, represented by circles, correspond to the possible output clock signals h, i, k and l of Figure 1. The multiplier values associated with the respective states are given besides the circles. The arrows in Figure 6 represent transitions between the states. The state is changed according to the straight arrows when an UP signal or a DOWN signal is generated by the ADC 17. If neither UP nor DOWN signal is generated, the state remains the same as indicated by the circular arrows in Figure 6.

In Figure 7, a similar state machine is shown with the difference that now the multipliers A and B can each assume the values of -1, 0 and +1, corresponding to eight possible states in 45° steps. Apart from this difference, the mechanism of this state machine is the same as that of the one shown in Figure 6.

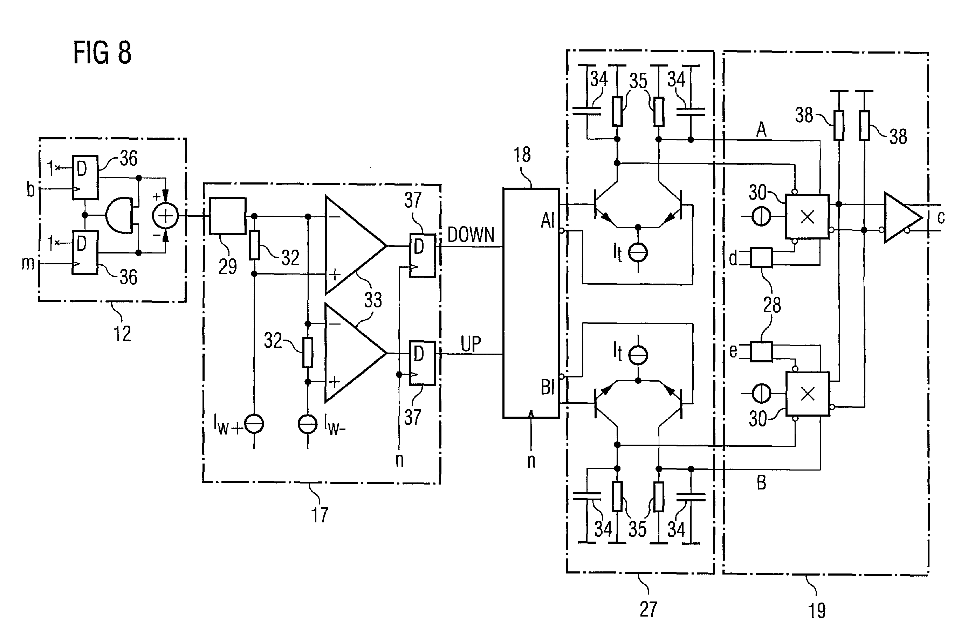

In Figure 8, a possible implementation of the blocks 12, 17, 18 and 19 of Figure 3 is shown. The phase detector 12 is a common type-4-phase-frequency detector (PFD) which compares the phases of the data clock signal b and the master clock signal m. A single differential, analog output is provided by subtracting the output of two latches 36. This output is subsequently low pass filtered by a low pass filter 29.

The analog-digital converter 17, in this case a 1.5 bit ADC, is implemented using two analog amplifiers 33 and voltage shifters or resistors 32. The upper and lower limits 21 and 22 are controlled by currents I_{w+} and I_{w}- via the resistors 32. The outputs of the amplifiers 33 are sampled by latches 37 which are clocked with an internal clock signal n which usually has a much lower frequency than the frequency of the signals b and m. For example, the frequency of the clock signals b and m may be 2.5 GHz, and the frequency of the internal clock signal n may be 20 MHz. This sampling is done to regenerate digital levels.

The UP and DOWN signals generated by the latches 37 this way are fed to a logic block 18 which can be implemented as a state machine as shown in Figures 6 and 7. The state machine is also clocked by the internal clock signal n with a frequency of, for example, 20 MHz. The range of suitable frequency is very broad, it is limited by loop stability at high frequencies and the maximum rate of change of the loop phase wander that is required to be compensated.

In the implementation shown, the multipliers AI and BI generated by the logic block 18 are further processed by a slope limiter 27 to limit the rate of change of the multipliers. Here, the slope limiters are realized by low pass filters comprising capacitors 34 and resistors 35. Thus, the maximum rate of change of the so-generated multipliers A and B is limited by this RC filter, to which a tail current Iₜ is supplied, R being the resistance of the resistors 35 and C being the capacity of the capacitors 34. The multipliers A and B are fed to multiplicators 30, which may be implemented as Gilbert cells. Also fed to the multiplicators 30 are the intermediate clock signals d and e. These are filtered by low pass filters 28 if they are, for example, rectangular signals, to obtain the wave forms shown in Figure 2. Instead of the low pass filters, other slope limiting means may be used.

However, in principle, other wave forms such as sine waves may be used. The two intermediate clock signals d and e may be generated by dividing a single clock by a factor of 2 using a master-slave flipflop. The output signals of the multiplicators 30 are added at common termination resistors 38 to produce the output clock signal c.

Of course, there are many possible variations to the embodiments described above. For example, instead of the phase and frequency detector 12 shown in Figure 8, a data transition phase detector (e.g. Alexander type) can be used to compare the phase of the data clock signal b (or the data signal a) and the master clock signal m.

Since the requirements for precision and speed of the analog-digital-converter 17 are low, other known implementations would work as well. Furthermore, the encoding of the output signals of the ADC 17 is not important, so codes other than UP/DOWN can be used.

A completely analog implementation of the state machine is possible, using for example linear integrators, gain cells and switches. But linearity of the elements is not a must.

The slope limiter 27 of Figure 8 may be also implemented using analog integrators (integrating switched DC currents through capacitors).

Other than dividing a single clock by a factor of 2 using master slave flipflops to generate the intermediate clock signals d and e, RC or LC elements or an integrator may be used.

Furthermore, the invention is not limited to the 90° or 45° steps of the cyclic phase stepper shown. Phase control in steps smaller than 45° can be implemented by using more possible values for the multipliers, by using intermediate clock signals with a smaller phase shift or by using more intermediate clock signals.

Also, an ADC 17 with a resolution higher than 1.5 bits can be used in conjunction with a logic block that compensates for small phase differences in small steps and large phase differences in larger steps. This would mean, for example, for the state machine shown in Figure 6 that also a direct transition between steps 180° apart would be possible.

The upper and lower limits 21 and 22 or the reference voltages for the ADC can be generated using a dummy phase detector of the same structure as the phase detector 12. This would decrease the dependence of the circuit on process variations, temperature and power supply voltages.

Furthermore, instead of Gilbert cells for phase interpolation, other analog multiplier circuits can be used. Also, multiplexers with three state outputs may be used.

It is, in principle, also possible to use rectangular intermediate clock signals d and e and AND-gates for interpolation. Finally, if the average level of the output of the phase detector 12 is achieved by limited bandwidth of the subsequent amplifiers and/or comparators, no special low pass filter 29 may be needed.

## Claims

1. Method for generating an output clock signal (c), comprising the steps of
(a1) deriving at least two further clock signals (d, e, f, g) having a predetermined phase shift from a master clock signal (m),
(a2) generating the output clock signal (c; h, i, k, l) by interpolating between the at least two further clock signals (d, e, f, g) derived from the master clock signal (m).

2. Method for generating an output clock signal (c) according to claim 1,
**characterized in that**
in step (b) the interpolating between the at least two further clock signals (d, e, f, g) is achieved by adding the amplitudes of the at least two further clock signals (d, e, f, g).

3. Method for generating an output clock signal (c) according to claim 1 or claim 2,
**characterized in that**
step (a) comprises the steps of
(a1) deriving at least two intermediate clock signals (d,e) having a predetermined phase shift (ϕ) from the master clock signal (m), and
(a2) generating each of the at least two further clock signals (d, e, f, g) by multiplying one of the at least two intermediate clock signals (d, e) with a respective multiplier (A, B).

4. Method for generating an output clock signal (c) according to claim 3,
**characterized in that**
the respective multipliers are changed with time depending on at least one first control signal (UP) indicating a desired phase change of the output clock signal (c) in a first direction and at least one second control signal (DOWN) indicating a desired phase change of the output clock signal (c) in a second direction so that the output clock signal (c) changes its phase in the direction indicated by the at least one first control signal (UP) and the at least one second control signal (DOWN).

5. Method for generating an output clock signal (c) according to claim 4,
**characterized in that**
the change of the multipliers (A, B) is effected according to a state machine (18) where the states represent predetermined values of the multipliers (A, B) and transitions between the states are effected according to respective values of the at least one first control signal (UP) and the at least one second control signal (DOWN).

6. Method for generating an output clock signal (c) according to claim 4 or claim 5,
**characterized in that**
the at least one first control signal (UP) comprises a plurality of first control signals indicating desired phase changes of different magnitudes and the at least one second control signal (DOWN) comprises a plurality of second control signals indicating desired phase changes of different magnitudes.

7. Method for generating an output clock signal (c) according to any one of claims 4 to 6,
**characterized in that**
the at least one first control signal (UP) and the at least one second control signal (DOWN) are determined according to a phase difference signal indicating a phase difference between the master clock signal (m) and a reference clock signal (b) whose phase is dependent on the phase of the output clock signal (c).

8. Method for generating an output clock signal (c) according to claim 7,
**characterized in that**
the at least one first control signal (UP) and the at least one second control signal (DOWN) are determined by comparing the phase difference with predetermined values (21,22), so that the at least one first control signal (UP) is activated when the phase difference is less than a predetermined first value (22) and the at least one second control signal is activated when the phase difference is more than a predetermined second value (21).

9. Method for generating an output clock signal (c) according to any one of the preceding claims,
**characterized in that**
a first intermediate clock signal (e) which is phase shifted by 90° with respect to the master clock signal (m) and as a second intermediate clock signal (d) the master clock signal (m) are used,
two further clock signals (d, e, f, g) are generated by multiplying the master clock signal (m) with a first multiplier (A) and the first intermediate clock signal (e) with a second multiplier (B), and
the output clock signal (c; h, i, k, l) is generated by adding the amplitudes of the two further clock signals (d, e, f, g).

10. Method for generating an output clock signal (c) according to claim 9,
**characterized in that**
the first multiplier (A) and the second multiplier (B) each have a value of -1 or +1.

11. Method for generating an output clock signal (c) according to claim 9,
**characterized in that**
the first multiplier (A) and the second multiplier (B) each have a value of -1, 0 or +1.

12. Method for generating an output clock signal (c) according to one of the preceding claims,
**characterized in that**
the method is used for adjusting a phase difference in a communication system using counter-directional clocking.

13. Apparatus for generating an output clock signal (c) having an input for a master clock signal (m) and an output for the output clock signal (c), comprising
phase shifting means for deriving at least two further clock signals (d, e, f, g) having a predetermined phase shift from the master clock signal (m), and
interpolating means for generating the output clock signal (c; h, i, k, l) by interpolating between the at least two further clock signals (d, e, f, g) derived from the master clock signal (m).

14. Apparatus for generating an output clock signal according to claim 13,
**characterized in that**
the phase shifting means are designed for deriving at least two intermediate clock signal (d, e) having a predetermined phase shift (ϕ) from the master clock signal (m) and for multiplying each of the at least two intermediate clock signals (d, e) with a respective multiplier (A, B) to generate the further clock signals (d, e, f, g).

15. Apparatus for generating an output clock signal (c) according to claim 14,
**characterized in that**
it further comprises slope limiting means for limiting a change rate of the multiplier.

16. Apparatus for generating an output clock signal (c) according to any one of claims 13 to 15,
**characterized in that**
it further comprises slope limiting means (28) for limiting the slope of the at least two further clock signals (d, e, f, g).

17. Apparatus for generating an output clock signal (c) according to claim 16,
**characterized in that**
the master clock signal is a basically rectangular signal and the slope limiting means for limiting the slope of the at least two further clock signals (d, e, f, g) comprise at least one low pass filter (28) having a time constant of 0.25 of a period of the master clock signal.

18. Apparatus for generating an output clock signal according to any one of claims 13 to 17,
**characterized in that**
it further comprises phase detection means (12) for detecting a phase difference between the master clock signal (m) and a reference signal (b) whose phase is dependent on the phase of the output clock signal(c), an analog-digital-converter (17) for converting the phase difference into a digital phase difference signals comprising at least one first control signal (UP) indicating a desired phase change of the output clock signal (c) in a first direction and at least one second control signal (DOWN) indicating a desired phase change of the output clock signal (c) in a second direction, and
analyzing means (18, 19) for evaluating the digital phase difference signals and generating the at least two further clock signals (d, e, f, g) according to the desired phase change of the output clock signal (c) indicated by the digital phase difference signals (UP, DOWN).

19. Apparatus according to any one of the claims 13 to 18,
**characterized in that**
the apparatus is designed to carry out a method according to any one of the claims 1 to 12.

20. Communication system with a transmitter (1) and a receiver (3),
**characterized in that**
it comprises an apparatus according to any one of claims 13 to 19 for synchronizing the phase of a data signal (a, b) received by the receiver (3) from the transmitter (1) with the phase of the master clock signal (m) generated by the receiver (3), the apparatus generating the output clock signal (c) and transmitting it to the transmitter(1).
